# FASCICULE DE BREVET EUROPEEN

(11) **EP 0 571 302 B1**
(45) Date de publication et mention de la délivrance du brevet: **20.08.1997**
(21) Numéro de dépôt: 93420195.5
(22) Date de dépôt: 14.05.1993
(51) Int. Cl.: H03F 1/52

(54) **Amplificateur avec limitation de courant de sortie**
Verstärker mit Ausgangsstrombegrenzung
Amplifier with limited output current

(30) Priorité: 18.05.1992 FR 9206384
(43) Date de publication de la demande: 24.11.1993
(73) Titulaire: SGS-THOMSON MICROELECTRONICS S.A., 94250 Gentilly (FR)
(72) Inventeur: Laot, Colette, F-38240 Meylan (FR); Majoux, Bernard, F-38240 Meylan (FR)
(74) Mandataire: de Beaumont, Michel

(56) Documents cités:
- WO-A-90/09703
- IEEE INTERNATIONAL SOLID STATE CIRCUITS CONFERENCE vol. 24, Février 1981, NEW YORK US pages 246 - 277 D.W. AULL ET AL 'TELECOMMUNICATION CIRCUITS' *

## Description

L'invention concerne les circuits intégrés, plus particulièrement mais non exclusivement ceux qui sont réalisés en technologie MOS (Métal Oxyde Semiconducteur) ou BIMOS (Bipolaire et Métal Oxyde Semiconducteur).

Un but de l'invention est de réaliser un amplificateur qui comporte une fonction de limitation du courant de sortie que peut fournir l'amplificateur.

Il peut être nécessaire en effet de limiter ce courant de sortie pour éviter de détruire le circuit intégré en cas de court-circuit à la sortie de l'amplificateur, ou même en cas de connexion d'une charge d'impédance trop faible à la sortie.

Cette fonction n'a pas toujours besoin d'être assurée par des éléments de circuit spécifiques. En effet, en technologie MOS par exemple, l'étage de sortie de l'amplificateur est le plus souvent constitué par un amplificateur en classe AB de gain en tension égal à 1. La technologie des transistors MOS est telle que la résistance interne d'un transistor, même en état de conduction maximale, limite le courant à une valeur raisonnable (qui dépend de sa géométrie), même si la sortie est en court-circuit. Et si le courant de court-circuit était encore trop fort par rapport à ce que peut supporter le transistor on pourrait encore insérer une résistance entre la borne d'alimentation et la source des transistors.

Toutefois, dans certains circuits, la limitation ainsi réalisée n'est plus possible : c'est le cas des amplificateurs dans lesquels on souhaite avoir une excursion de tension de sortie très grande, c'est-à-dire dont les valeurs extrêmes sont très proches des valeurs de tension d'alimentation. A titre d'exemple, si les potentiels d'alimentation sont respectivement de 0 et 10 volts, on souhaite que la tension de sortie de l'amplificateur puisse aller jusqu'à moins de 50 ou 100 millivolts de ces valeurs sur charge de 10 kiloohms, ou jusqu'à 600 millivolts de ces valeurs sur charge de 600 ohms.

Le document IEEE International Solid State Circuits Conference vol. 24, février 1981, New York US, pp. 246-277, D.W AULL & al "Telecommunication circuits" divulgue un exemple d'un tel amplificateur.

Les circuits de ce type excluent a priori qu'on insère une résistance de limitation dans la source des transistors de sortie, car cette résistance réduit automatiquement l'excursion de tension de sortie de l'amplificateur, proportionnellement à la valeur de la résistance. D'autre part, ces circuits exigent en pratique de gros transistors de sortie, ayant une aptitude à conduire un courant élevé, et par conséquent les transistors ne pourront pas servir à limiter automatiquement le courant à une valeur raisonnable en cas de court-circuit.

C'est pourquoi on cherche à proposer selon l'invention un circuit actif de limitation de courant, qui permet, aussi efficacement que possible et sans inconvénients secondaires (tels que des instabilités ou des risques d'oscillations), de limiter le courant de sortie tout en conservant une excursion de tension de sortie aussi élevée que possible.

L'amplificateur selon la présente invention telle que définie dans les revendications 1 à 8 comporte un étage de sortie et un circuit de limitation de courant ; l'étage de sortie comprend deux transistors de sortie, en série entre deux bornes d'alimentation, et au moins une première borne de commande permettant de contrôler la conduction du premier transistor ; le circuit de limitation de courant comprend une résistance en série entre une sortie de l'étage et le point de jonction entre les deux transistors de sortie, et au moins un transistor de limitation ayant sa grille reliée à une extrémité de la résistance et sa source reliée à une autre extrémité, le transistor de limitation ayant son drain relié à un transistor monté en diode et conduisant un courant lorsque le courant de sortie dans la résistance dépasse une valeur déterminée dans un premier sens ; il est prévu de plus un transistor de recopie du courant dans le transistor monté en diode, le drain du transistor de recopie étant relié à travers un transistor d'isolation à la première borne de commande ; le transistor d'isolation est de plus connecté de manière à être rendu conducteur lorsque le courant dans le transistor de limitation dépasse un seuil déterminé.

De préférence, le transistor d'isolation a sa source reliée au drain du transistor de recopie, son drain relié à la première borne de commande, sa grille reliée à la grille du transistor de recopie, et son substrat connecté au potentiel le plus négatif du circuit (dans le cas où ce transistor d'isolation est à canal N).

En pratique, le drain du transistor de recopie sera relié à une source de tension d'alimentation par l'intermédiaire d'une résistance.

Pour que le circuit de limitation agisse également lorsque le courant de sortie circule en sens inverse dans la résistance, il est prévu de préférence un deuxième transistor de limitation ayant sa grille et sa source reliées respectivement chacun à une extrémité de la résistance, ce transistor de limitation étant rendu conducteur lorsque le courant dans la résistance dépasse une valeur déterminée (dans le sens inverse du courant qui rend conducteur le premier transistor de limitation) ; à cet effet, le drain de ce deuxième transistor de limitation est connecté de manière à agir sur une deuxième borne de commande du circuit, dans un sens propre à réduire le courant dans le deuxième transistor de sortie en cas de dépassement d'une valeur maximale admissible du courant de sortie.

Bien que l'invention soit destinée préférentiellement à un amplificateur en technologie MOS ou BIMOS, elle peut également être transposée en un schéma n'utilisant que des transistors bipolaires.

D'autres caractéristiques de l'invention apparaitront à la lecture de la description détaillée qui suit et qui est faite en relation avec les dessins annexés dans lesquels :
- la figure 1 représente un schéma de principe d'amplificateur à partir duquel est construite la présente invention ;
- la figure 2 représente un schéma d'amplificateur selon un mode de réalisation préféré de l'invention ;
- la figure 3 représente une courbe expliquant les avantages du schéma de la figure 2.

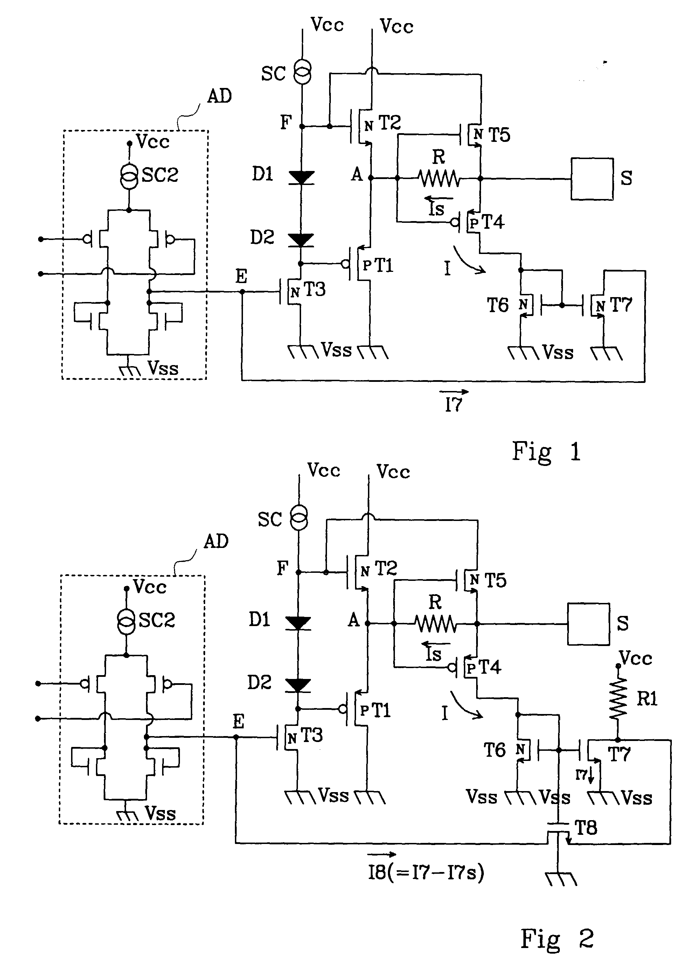

Un étage de sortie classique en classe AB d'un amplificateur opérationnel en technologie CMOS comprend en général (voir figure 1) deux transistors de sortie T1 et T2, de types de conductivité opposés ou de même type, en série entre deux bornes d'alimentation Vcc et Vss du circuit. Dans l'exemple décrit il y a un transistor à canal P (T1) ayant son drain relié à Vss et un transistor à canal N (T2) ayant son drain relié à la borne Vcc, mais l'invention pourrait s'appliquer à des configurations différentes d'amplificateur en classe AB (transistor à canal P connecté à Vcc, ou alors transistors de même type de conductivité).

La limitation de courant active selon l'invention comprend d'abord une résistanoe R placée entre la sortie S de l'étage et un noeud A qui est le point de jonction des deux transistors T1 et T2. Cette résistance sera parcourue par le courant de sortie de l'amplificateur.

Le signal à amplifier est appliqué à une entrée E d'un étage intermédiaire de l'amplificateur. Cet étage intermédiaire comprend ici le transistor T3, les diodes D1, D2, et la source de courant SC. Il pilote l'étage de sortie en agissant sur les grilles des transistors T1 et T2. Dans l'exemple décrit, le transistor T3 est à canal N et a sa source à Vss, son drain étant relié à une charge constituée par les deux diodes D1 et D2 en série avec la source de courant SC. La source de courant SC polarise les deux diodes en direct. La grille de T1 est reliée directement au drain de T3 ; la grille de T2 est reliée au point de jonction entre la source de courant SC et les diodes. Cette disposition maintient entre les grilles de T1 et T2 une différence de potentiel égale à la chute de tension en direct dans les diodes, c'est-à-dire environ 1,4 volts.

Le transistor T3 agit ainsi sur les transistors T1 et T2 pour modifier leur conduction ; l'action sur la conduction de T1 est dans le sens contraire de l'action sur T2 puisque les transistors sont de type opposés et reçoivent des variations de même sens sur leur grille.

Pour la commodité de la description qui suit et pour la référence aux revendications, on appellera "première borne de commande" l'entrée E et "deuxième borne de commande" le noeud F constitué par la grille du transistor T2. On verra en effet que le circuit de limitation selon l'invention agit sur ces deux points pour limiter le courant de sortie de l'amplificateur.

Le circuit de limitation prévu sur la figure 1 comporte, outre la résistance R, les deux transistors T4 et T5, dont l'un (T4) est à canal P et l'autre (T5) est à canal N, et qui ont tous deux leur grille reliée au noeud A et leur source reliée à la sortie S. On remarquera qu'il est possible d'inverser les sens de connexion de ces transistors si on inverse aussi leur type de conductivité : le sens de connexion doit être tel qu'on réduise la conduction du transistor de sortie qui tend à être parcouru par un courant trop fort.

On comprend que si le courant de sortie circulant dans la résistance R dépasse un seuil déterminé, la chute de tension grille-source des transistors de limitation T4 et T5 dépassera le seuil de conduction de ces transistors. Pour le transistor T4 à canal P, le seuil de conduction sera dépassé pour un courant rentrant, de la borne S vers la borne A, tandis que pour le transistor T5 à canal N, le seuil de conduction sera dépassé pour un courant sortant de la borne A vers la borne S.

Le drain du transistor T5 sert à commander la réduction de la conduction du transistor T2. Ce drain peut être connecté directement à la grille du transistor T2, c'est-à-dire à la deuxième borne de commande F. Si le seuil de conduction de T5 est dépassé par suite d'une impédance de charge trop faible en courant sortant, la mise en conduction de T5 abaisse le potentiel de grille du transistor T2 (canal N) et réduit le courant sortant qui est justement fourni par le transistor T2.

Le drain du transistor T4 sert à contrôler la conduction du transistor T1 en cas de dépassement de courant rentrant. Dans l'exemple décrit, le drain du transistor T4 est connecté à un miroir de courant constitué par deux transistors T6 et T7. Le transistor T6 (canal N) est monté en diode (grille et drain réunis), et est connecté entre le drain de T4 et Vss. Le transistor T7 est un transistor de recopie du courant dans le transistor T6 (courant qui est le même que le courant du transistor T4). Les grilles de T6 et T7 sont connectées ensemble et leurs sources sont à Vss. Le drain du transistor T7 est utilisé pour contrôler la conduction du transistor T3 de l'étage intermédiaire et par conséquent la conduction du transistor T1. Le plus simple est de connecter directement le drain du transistor T7 à la grille du transistor T3 (schéma de la figure 1). Cette grille reçoit par ailleurs, sur la borne de commande E à laquelle elle est connectée, un signal d'entrée qu'on désire amplifier.

Ce signal qu'on désire amplifier provient par exemple de la sortie d'un amplificateur différentiel AD ayant deux branches différentielles alimentées par une source de courant commune SC2.

La mise en conduction du transistor T4, en cas de dépassement de valeur limite de courant rentrant, engendre un courant I dans le transistor T6 et donc un courant en principe identique 17 = I dans le transistor T7 (si le rapport de recopie des transistors T6 et T7 est 1) ; ce courant 17 est prélevé sur l'entrée E, c'est-à-dire qu'il vient de la branche de sortie de l'amplificateur différentiel AD reliée à l'entrée E. Dès que ce courant dépasse le courant maximal que peut fournir la branche de sortie de l'amplificateur différentiel AD, le potentiel de l'entrée E chute ; la conséquence en est une augmentation du potentiel de grille du transistor T1 et donc une réduction de la conduction de celui-ci.

On obtient donc bien une limitation du courant rentrant de l'amplificateur.

Ce circuit de la figure 1 présente cependant parfois des inconvénients qui peuvent être dus à la progressivité de la mise en oeuvre de la limitation de courant.

Selon un mode de réalisation préféré représenté à la figure 2, on évite ces inconvénients en prévoyant un transistor supplémentaire d'isolation T8. Il sert à couper la liaison entre le transistor T7 et l'entrée E tant que le transistor T4 n'est encore que partiellement mis en conduction. Le transistor T8 est ensuite rendu franchement conducteur aussitôt que le courant dans le transistor T4 dépasse un seuil déterminé.

Ainsi, en l'absence de dépassement d'un seuil de courant (rentrant) admissible dans l'étage de sortie, et également dans la phase limite où le courant de sortie dans la résistance R commence à rendre conducteur le transistor T4, il n'y a pas ou pratiquement pas de réaction de la sortie sur l'entrée, ce qui est favorable (pour résoudre les problèmes d'instabilité).

Au contraire, lorsque le transistor T4 dépasse un certain seuil de conduction, le transistor T8 devient brusquement conducteur, le transistor T7 absorbe alors suffisamment de courant pour abaisser le potentiel de l'entrée E (cela se produit quand le transistor T7 absorbe tout le courant que peut fournir la sortie de l'amplificateur AD).

Dans la réalisation préférentielle de la figure 2, le drain du transistor de recopie T7 est de plus relié par une résistance R1 à la borne d'alimentation positive Vcc. Bien qu'elle ne soit pas strictement nécessaire pour que le circuit de limitation de courant fonctionne, cette résistance favorise la stabilité du circuit en introduisant une constante de temps de réaction dans la boucle oonstituée par le circuit de limitation de courant.

Le transistor T8 a de préférence sa grille connectée à la grille des transistors T6 et T7, sa source reliée au drain du transistor T7 et son drain relié à l'entrée E. De plus, il est souhaitable que le substrat du transistor T8 (c'est-à-dire la région semiconductrice dans laquelle sont diffusés la source et le drain de ce transistor) soit connecté au potentiel le plus bas du circuit (Vss) plutôt que d'être connecté à la source ou d'être laissé flottant.

Le circuit fonctionne alors de la manière suivante, lorsque le courant de sortie Is (dans le sens rentrant) s'approche de la valeur maximale autorisée : le courant Is développe une tension R.Is aux bornes de la résistance R. Lorsque cette tension atteint la tension de seuil Vt4 nécessaire à la mise en conduction du transistor T4, celui-ci commence à conduire un courant I qui passe dans le transistor T6 ; le courant du transistor T6 est recopié sous forme d'un courant 17 dans le transistor T7. Au début, le potentiel de source du transistor T8 est trop élevé et son potentiel de grille trop bas pour que le transistor T8 conduise. Le courant du transistor T7 vient donc uniquement de la résistance R1 et produit dans cette résistance une chute de tension R1.I7.

Il y a un seuil de courant du transistor T4 pour lequel on a les conditions suivantes : la tension de grille de T6 et T7, donc de T8, est suffisamment haute du fait que T6 et T7 conduisent un courant, et la tension de source de T8 est suffisamment basse du fait de la chute de tension R1.I7 dans la résistance R1, pour que la tension grille-source Vgs8 du transistor T8 dépasse le seuil Vt8 de conduction de ce transistor. T8 devient alors franchement conducteur car toute augmentation même légère du courant I dans le transistor T4 se traduit par une forte augmentation de tension grille-source de T8.

Le transistor T8 est d'ailleurs choisi relativement petit devant le transistor T7 pour que T8 soit franchement conducteur dès lors que la chute de tension dans R1 est presque égale à Vcc.

La conduction de T8 prélève alors un courant en provenance de l'entrée E et dirige ce courant dans le transistor T7.

Les transistors sont dimensionnés de telle sorte que le courant I8 prélevé par le transistor T8 soit très vite supérieur au courant maximal disponible sur l'entrée E. Dans le cas où l'entrée E est pilotée par l'amplificateur différentiel AD, on s'arrange donc pour que le courant prélevé par T8 soit facilement supérieur au courant maximal que peut fournir la branche de sortie de l'amplificateur différentiel AD. La tension en E chute alors et interrompt la conduction du transistor T3 donc celle du transistor T1.

Si on appelle Vgs7 la tension grille-source du transistor T7 parcouru par un courant I7s au moment où le transistor T8 va devenir conducteur, et Vt8 la tension de seuil de conduction de T8, on peut dire que la conduction du transistor T8 intervient pour un seuil de courant I7s égal à (Vcc - Vgs7 + Vt8)/R1.

La mise en conduction de T8 intervient lorsque le courant I dans T4 dépasse la valeur qui engendre (par recopie) un courant I7s dans T7. Si on suppose que le coefficient de recopie de courant entre T6 et T7 est 1, alors la valeur I = I7s = (Vcc + Vgs7 - Vt8)/R1 représente le seuil de courant dans le transistor T4 pour lequel la limitation de courant est effectivement mise en service.

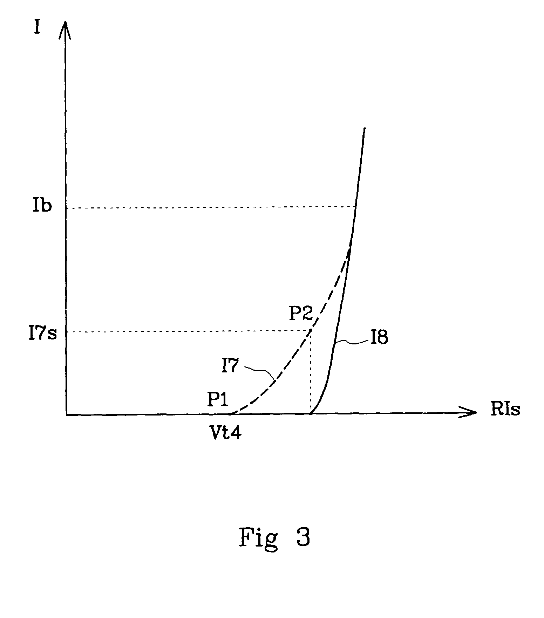

La figure 3 représente des courbes de variations de courant I8 dans le transistor T8 en fonction du courant de sortie Is de l'amplificateur ou de la tension R.Is aux bornes de la résistance R. La courbe en pointillés représente la variation de I7 dans un schéma du type de la figure 1, alors que la courbe en traits pleins représente la variation de I8 dans le schéma de la figure 2. L'avantage de la configuration de la figure 2 est très net : le courant prélevé I8 est pratiquement nul en dessous d'un certain seuil (plus élevé que dans le cas de la figure 1, ce qui veut dire que la valeur de la résistance R doit être choisie en fonction du schéma adopté) ; ce courant I8 augmente très rapidement au delà de ce seuil. On a supprimé toute une zone de fonctionnement douteux (en traits pointillés) dans laquelle la limitation de courant ne fonctionnait qu'à moitié mais introduisait une boucle de réaction néfaste dans l'amplificateur. Sur les courbes de la figure 3, le point P1 représente le début de mise en conduction du transistor T4, et le point P2 représente un seuil de courant dans T4 (ou, par recopie, dans T7), qui correspond au seuil de mise en conduction du transistor T8 dans le schéma de la figure 2.

## Revendications

1. Amplificateur comportant un étage de sortie et un circuit de limitation de courant, l'étage de sortie comprenant deux transistors de sortie (T1, T2) en série entre deux bornes d'alimentation (Vcc, Vss), et au moins une première borne de commande (E) permettant de contrôler la conduction du premier transistor (T1) ; et le circuit de limitation de courant comprenant une résistance (R) en série entre une sortie (S) de l'étage et le point de jonction (A) entre les deux transistors de sortie, avec au moins un transistor de limitation (T4) ayant sa grille reliée à une extrémité de la résistance et sa source reliée à une autre extrémité, dans lequel
- le transistor de limitation (T4) a son drain relié à un transistor monté en diode (T6) et conduit un courant lorsque le courant de sortie dans la résistance dépasse une valeur déterminée dans un premier sens ;
- il est prévu de plus un transistor (T7) de recopie du courant dans le transistor monté en diode (T6), caractérisé en ce que le drain du transistor de recopie est relié à travers un transistor d'isolation (T8) à la première borne de commande (E) et que le transistor d'isolation (T8) est connecté de manière à être rendu conducteur lorsque le courant dans le transistor de limitation (T4) dépasse un seuil déterminé.

2. Amplificateur selon la revendication 1, caractérisé en ce que le transistor d'isolation (T8) a sa source reliée au drain du transistor de recopie (T7), son drain relié à la première borne de commande (E), sa grille reliée à la grille du transistor de recopie (T7), et son substrat connecté au potentiel le plus négatif du circuit (pour un transistor à canal N).

3. Amplificateur selon la revendication 2, caractérisé en ce que le drain du transistor de recopie est relié à une source de tension d'alimentation (Vcc) par l'intermédiaire d'une résistance (R1).

4. Amplificateur selon l'une des revendications 1 à 3, caractérisé en ce qu'il est prévu un deuxième transistor de limitation (T5) ayant sa grille et sa source reliées respectivement chacune à une extrémité de la résistance de sortie (R), ce transistor de limitation (T5) étant rendu conducteur lorsque le courant dans la résistance (R) dépasse une valeur déterminée dans le sens inverse du courant qui rend conducteur le premier transistor de limitation, le drain de ce deuxième transistor de limitation (T5) étant connecté de manière à agir sur une deuxième borne de commande (F) du circuit, dans un sens propre à réduire le courant dans le deuxième transistor de sortie en cas de dépassement de valeur du courant de sortie.

5. Amplificateur selon la revendication 4, caractérisé en ce que le drain du deuxième transistor de limitation (T5) est connecté directement à la grille du deuxième transistor de sortie (T2).

6. Amplificateur selon l'une des revendications 4 et 5, caractérisé en ce que la première borne de commande (E) est la grille d'un transistor amplificateur (T3) dont le drain est relié à la grille du premier transistor de sortie.

7. Amplificateur selon la revendication 6, caractérisé en ce que la deuxième borne de commande (F) est reliée au drain du transistor amplificateur par un ensemble de diodes (D1, D2) qui sont par ailleurs polarisées en conduction directe.

8. Amplificateur selon l'une des revendications 4 à 7, caractérisé en ce que les transistors de limitation sont l'un à canal P et l'autre à canal N.

## Patentansprüche

1. Verstärker mit einer Ausgangsstufe und einer Strombegrenzungsschaltung, wobei die Ausgangsstufe zwei Ausgangstransistoren (T1, T2) in Reihe zwischen zwei Speise- bzw. Versorgungsanschlüssen (Vcc, Vss) und wenigstens einen ersten Steueranschluß (E), welcher eine Steuerung der Leitung des ersten Transistors (T1) gestattet, aufweist, und wobei die Strombegrenzungsschaltung einen Widerstand (R) in Reihe zwischen einem Ausgang (A) der Stufe und dem Verbindungspunkt (A) zwischen den beiden Ausgangstransistoren mit wenigstens einem Begrenzungstransistor (T4) aufweist, dessen Gate mit dem einen Ende des Widerstands und dessen Source mit dessen anderem Ende verbunden sind, wobei
- der Drain-Anschluß des Begrenzungstransistors (T4) mit einem als Diode geschalteten Transistor (T6) verbunden ist und einen Strom leitet, sobald der Ausgangsstrom in dem Widerstand einen vorgegebenen Wert in einem ersten Richtungssinn übersteigt;
- des weiteren ein Transistor (T7) zur Duplizierung des Stroms in dem als Diode geschalteten Transistor (T6) vorgesehen ist,
dadurch gekennzeichnet, daß
der Drainanschluß des Duplizierungstransistors über einen Trenn- bzw. Isoliertransistor (T8) mit dem ersten Steueranschluß (E) verbunden ist und
der Trenn- bzw. Isoliertransistor (T8) so angeschlossen ist, daß er leitend wird, sobald der Strom in dem Begrenzungstransistor (T4) einen vorgegebenen Schwellwert übersteigt.

2. Verstärker nach Anspruch 1, dadurch gekennzeichnet daß der Source-Anschluß des Trenn- bzw. Isoliertransistors (T8) mit dem Drain-Anschluß des Duplizierungstransistors (T7), sein Drain-Anschluß mit dem ersten Steueranschluß (E) und sein Gate mit dem Gate des Duplizierungstransistors (T7) verbunden sind, und daß sein Substrat mit dem negativsten Potential der Schaltung (für einen N-Kanal-Transistor) verbunden ist.

3. Verstärker nach Anspruch 2, dadurch gekennzeichnet, daß der Drain-Anschluß des Duplizierungstransistors über einen Widerstand (R1) mit einer Speisespannungsquelle (Vcc) verbunden ist.

4. Verstärker nach einem der Ansprüche 1 bis 3, dadurch gekennzeichnet, daß ein zweiter Begrenzungstransistor (T5) vorgesehen ist, dessen Gate und dessen Source jeweils mit einem Ende des Ausgangswiderstands (R) verbunden sind, wobei dieser Begrenzungstransistor (T5) leitend gemacht wird, sobald der Strom in dem Widerstand (R) einen vorgegebenen Wert in dem zum Richtungssinn des Stroms, welcher den ersten Begrenzungstransistor leitend macht, entgegengesetzten Sinn übersteigt, und wobei der Drain-Anschluß des zweiten Begrenzungstransistors (T5) so verbunden ist, daß er auf einen zweiten Steueranschluß (F) der Schaltung einwirkt, in einem geeigneten Sinn zur Verringerung des Stroms in dem zweiten Ausgangstransistor (T5), falls der vorgegeben Wert des Ausgangsstroms überschritten wird.

5. Verstärker nach Anspruch 4, dadurch gekennzeichnet, daß der Drain-Anschluß des zweiten Begrenzungstransistors (T5) direkt mit dem Gate des zweiten Ausgangstransistors (T2) verbunden ist.

6. Verstärker nach einem der Ansprüche 4 und 5, dadurch gekennzeichnet, daß der erste Steueranschluß (E) das Gate eines Verstärkertransistors (T3) ist, dessen Drain-Anschluß mit dem Gate des ersten Ausgangstransistors verbunden ist.

7. Verstärker nach Anspruch 6, dadurch gekennzeichnet daß der zweite Steueranschluß (F mit dem Drain-Anschluß des Verstärkertransistors über eine Gruppe von in Durchlaßrichtung vorgespannten Dioden (D1, D2) verbunden ist.

8. Verstärker nach einem der Ansprüche 4 bis 7, dadurch gekennzeichnet, daß von den Begrenzungstransistoren einer vom P-Kanal-Typ und der andere vom N-Kanal-Typ ist.

## Claims

1. An amplifier including an output stage and a current limiting circuit, said output stage including two output transistors (T1, T2) in series between two supply terminals (Vcc, Vss), and at least one first control terminal (E) for controlling the conduction of said first transistor (T1); and said current limiting circuit including a resistor (R) in series between an output (S) of said output stage and a junction (A) between said two output transistors, with at least one limitation transistor (T4) having its gate connected to one end of said resistor and its source connected to the other end, wherein:
- said limitation transistor (T4) has its drain connected to a diode-connected transistor (T6) and conducts a current when the output current in said resistor exceeds a determined value in a first direction;
- an additional transistor (T7) duplicates the current in said diode-connected transistor (T6),
characterized in that:
the drain of said duplicating transistor is connected through an isolation transistor (T8) to the first control terminal (E), and
said isolation transistor (T8) is connected so as to be rendered conductive when the current in said limitation transistor (T4) exceeds a predetermined threshold.

2. An amplifier according to claim 1, characterized in that said isolation transistor (T8) has its source connected to the drain of said duplicating transistor (T7), its drain connected to said first control terminal (E), its gate connected to the gate of said duplicating transistor (T7), and its substrate connected to the most negative voltage of the circuit (when said isolation transistor is an N-channel transistor).

3. An amplifier according to claim 2, characterized in that the drain of said duplicating transistor is connected to a supply voltage source (Vcc) through a resistor (R1).

4. An amplifier according to any of claims 1 to 3, characterized in that there is provided a second limitation transistor (T5) having its gate and its source respectively connected to a terminal of said output resistor (R), said limitation transistor (T5) being rendered conductive when the current in said resistor (R) exceeds a predetermined value in the reverse direction of the current which renders the first limitation transistor conductive, the drain of said second limitation transistor (T5) being connected so as to act on a second control terminal (F) of the circuit, in a direction appropriate to decrease the current in said second output transistor when the output current exceeds said predetermined value.

5. An amplifier according to claim 4, characterized in that the drain of said second limitation transistor (T5) is directly connected to the gate of said second output transistor (T2).

6. An amplifier according to claim 4 or 5, characterized in that said first control terminal (E) is the gate of an amplifying transistor (T3) whose drain is connected to the gate of said first output transistor.

7. An amplifier according to claim 6, characterized in that said second control terminal (F) is connected to the drain of said amplifying transistor through an assembly of diodes (D1, D2) which are biased in forward direction.

8. An amplifier according to any of claims 4 to 7, characterized in that one of said limitation transistors is a P-channel transistor, and the other an N-channel transistor.
